**Europäisches Patentamt**

**European Patent Office**

**Office européen des brevets**

(11) Numéro de publication: **0 313 481**
**A1**

# (12) DEMANDE DE BREVET EUROPEEN

(21) Numéro de dépôt: **88420353.0**

(22) Date de dépôt: **18.10.88**

(51) Int. Cl.⁴: **C 30 B 13/34**
**H 01 L 21/20**

(30) Priorité: **22.10.87 FR 8714954**

(43) Date de publication de la demande:
**26.04.89 Bulletin 89/17**

(84) Etats contractants désignés: **DE FR GB IT NL**

(71) Demandeur: **DUTARTRE, Didier**
**4, allée du Bret**
**F-38240 Meylan (FR)**

(72) Inventeur: **DUTARTRE, Didier**
**4, allée du Bret**
**F-38240 Meylan (FR)**

(74) Mandataire: **de Beaumont, Michel**
**1bis Rue Champollion**
**F-38000 Grenoble (FR)**

(54) **Procédé de recristallisation de couches minces.**

(57) La présente invention concerne un procédé de fabrication de couches minces monocristallines de silicium sur isolant, par recristallisation d'un matériau en couche mince (3) déposé sur un subtrat (1) et recouvert d'une produit encapsulant, par chauffage d'une bande dudit matériau au dessus de sa température de fusion et déplacement de cette bande fondue le long du substrat. Ce procédé consiste, avant le traitement par fusion, à modifier, selon des bandes sensiblement orthogonales ou obliques par rapport à la direction de la bande fondue, la structure d'un élément au moins de l'ensemble du substrat (1,2), du matériau (3) et de l'encapsulant (4) pour former des bandes d'une première structure propre à retarder le front de solidification et des bandes d'une autre structure propre à faire avancer le front de solidification, les bandes de la première structure et de la deuxième structure étant alternées.

Figure 3A

EP 0 313 481 A1

**Description**

## PROCÉDÉ DE RECRISTALLISATION DE COUCHES MINCES

La présente invention concerne un procédé de fabrication de couches minces monocristallines de silicium sur isolant, les défauts cristallins de cette couche de silicium étant localisés en des emplacements prédéterminés.

De telles couches minces monocristallines de silicium sur isolant (SSI) ont principalement comme application la réalisation de circuits électroniques à haute densité dits circuits intégrés. De la façon la plus courante à l'heure actuelle, les circuits intégrés sont formés sur des substrats de silicium monocristallin massif (plaquette de silicium d'une épaisseur de l'ordre de quelques dixièmes de millimètres et d'un diamètre allant de 50 à 150 millimètres). Les avantages des circuits intégrés formés sur SSI par rapport aux circuits intégrés formés sur silicium massif sont aujourd'hui bien connus et se basent essentiellement sur la résistance aux rayonnements ionisants des circuits formés sur SSI, la simplicité de l'isolement entre composants qui peuvent être isolés de façon satisfaisante aussi bien électriquement que thermiquement ce qui élimine de nombreux effets secondaires nocifs des circuits intégrés formés sur silicium massif.

De façon classique, la structure SSI est constituée d'un substrat de silicium sur lequel on a formé une couche isolante, couramment de l'oxyde de silicium $SiO_2$ qui est ensuite recouverte d'une couche mince (d'une épaisseur de l'ordre de $10^{-3}$ mm) de silicium (dite couche de SSI). Le silicium déposé est, selon les modes de dépôt, polycristallin ou amorphe et il s'agit de le recristalliser. Pour effectuer cette recristallisation, divers procédés ont été utilisés parmi lesquels celui qui paraît le plus prometteur actuellement consiste à revêtir la couche de silicium d'un produit encapsulant, à former sur un bord de la plaquette, par chauffage, une zone fondue et à déplacer cette zone fondue d'un bord à l'autre de la plaquette. Néanmoins, si ce procédé est réalisé de la façon simple présentée ci-dessus, la couche de SSI formée sera affectée de très nombreux défauts cristallins.

Pour améliorer la structure cristalline de la couche de SSI, des premières tentatives ont consisté à prévoir des zones de contact entre la couche de SSI et le substrat de silicium sous-jacent à la couche isolante. On espère ainsi que la recristallisation se fera selon l'orientation assurée par les zones initiales de germination du silicium sous-jacent. De telles méthodes ont parfois donné des résultats satisfaisants mais elles présentent l'inconvénient inhérent de nécessiter la prévision de zones de germination, c'est-à-dire à tout le moins des zones au niveau desquelles la couche mince de silicium n'est plus isolée du substrat. Il faut alors prévoir des étapes ultérieures de réisolement. D'autres inconvénients de ces procédés sont exposés dans la littérature.

D'autres procédés de recristallisation ont consisté à essayer de localiser les défauts cristallins dans des zones prévues à l'avance de la couche de SSI.

Ces procédés de recristallisation à localisation de défauts consistent essentiellement à former des bandes de discontinuité dans l'empilement [substrat / matériau à recristalliser (couramment du silicium) / encapsulant] transverses à la direction de la bande fondue de recristallisation.

Toutefois, en pratique, pour que la localisation des défauts soit satisfaisante et qu'il ne se présente pas de défauts entre les bandes de localisation, celles-ci ne peuvent être trop écartées, un ordre de grandeur pratique à l'heure actuelle étant de l'ordre de 40 µm. Ces bandes créent une discontinuité du front de solidification de la zone fondue pour localiser des défauts au niveau desdites bandes.

Un autre procédé de localisation de défauts, similaire à première vue au précédent, est le procédé de graphoépitaxie dans lequel on forme des bandes de discontinuité mais où ces bandes ont pour objet non pas de moduler le front de solidification mais d'orienter le cristal formé lors de la recristallisation. En graphoépitaxie, les bandes ont un relief beaucoup moins marqué que quand on cherche à obtenir une modulation du front de solidification. Par exemple, dans un article de M. W. GEIS et al, paru dans Applied Physics Letters du 1er juillet 1979, pages 71 à 74, on trouve des motifs de graphoépitaxie dont le pas est de 3,8 µm et dont la profondeur est de 0,1 µm. Dans un autre article de H. I. SMITH, M. W. GEIS et al, paru dans Journal of Crystal Growth, 1983, pages 527 et suivantes, on trouve des motifs dont la hauteur est de 0,025 µm et dont le pas est de 0,32 µm. A ce jour, à la connaissance de l'inventeur, les techniques de graphoépitaxie n'ont pas donné de résultats satisfaisants, c'est-à-dire qu'elles n'ont pas permis d'obtenir sur des plaquettes de silicium sur isolant des bandes monocristallines de largeur convenable.

Enfin, une demande de brevet français 85 06001 déposée le 19 avril 1985 par Michel HAOND propose de combiner les procédés par modulation du front de solidification et par graphoépitaxie. Ainsi, comme le représente par exemple la figure 3 de ce document, on trouve alternativement sur une plaquette des bandes 8 relativement importantes de modulation du front de solidification d'une largeur de 3 à 6 µm et d'une hauteur de 0,5 à 1 µm et des bandes 14 d'une largeur de 0,1 à 1 µm dont la hauteur n'est pas précisée mais, l'auteur faisant référence aux articles de GEIS susmentionnés, qui peut être estimée à une valeur comprise entre 0,025 µm et 0,1 µm. Il est précisé que ce deuxième type de bande a un objet de graphoépitaxie c'est-à-dire d'orientation des cristaux.

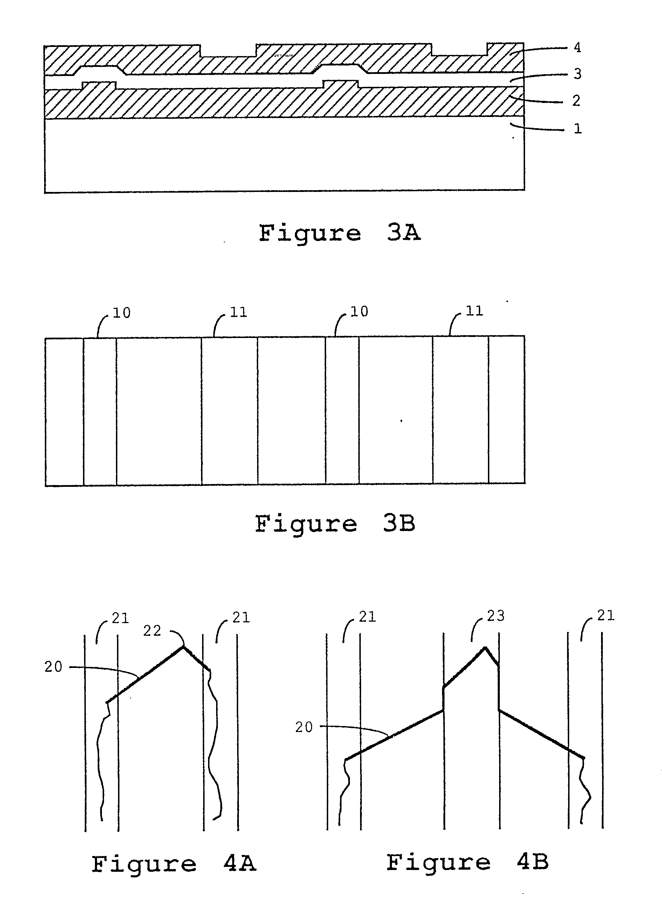

A la connaissance de la demanderesse, ce type de combinaison n'a pas permis d'amélioration notable par rapport à l'usage des seules bandes de modification du front de solidification, c'est-à-dire des seules bandes 8 de la figure 3 du document mentionné. En effet, on n'a pas pu par ce moyen obtenir des intervalles plus larges entre bandes de modulation du front de solidification en conservant une structure monocristalline entre ces bandes.

Ainsi, un objet de la présente invention est de prévoir un nouveau procédé de recristallisation d'un matériau tel que du silicium, par fusion de zone et localisation de défauts dans des bandes transverses ou obliques par rapport à la direction de déplacement de la bande chauffante, qui permette d'élargir l'écart entre bandes ou plus exactement l'écart entre zones de localisation de défauts tout en permettant de conserver entre ces bandes une structure monocristalline.

Pour atteindre cet objet ainsi que d'autres, la présente invention se base sur une étude théorique d'où il a résulté une classification des modifications de l'ensemble [substrat / matériau à recristalliser / encapsulant] en deux catégories, les structures permettant d'obtenir un retard du front de solidification et les structures permettant d'obtenir une avance du front de solidification.

Ainsi, la présente invention prévoit un procédé de recristallisation d'un matériau en couche mince déposé sur un substrat en recouvert d'un produit encapsulant, par chauffage d'une bande dudit matériau au dessus de sa température de fusion et déplacement de cette bande fondue le long du substrat, consistant, avant le traitement par fusion, à modifier, selon des bandes sensiblement orthogonales ou obliques par rapport à la direction de la bande fondue, la structure d'un élément au moins de l'ensemble du substrat, du matériau et de l'encapsulant pour former des bandes d'une première structure propres à retarder le front de solidification et des bandes d'une autre structure propres à faire avancer le front de solidification, les bandes de la première structure et de la deuxième structure étant alternées.

Selon un mode de réalisation de la présente invention, le substrat comprend une plaquette une silicium monocristallin revêtue d'une couche d'oxyde de silicium, le matériau à recristalliser est du silicium et la couche d'encapsulant de l'oxyde de silicium.

Par ce procédé, on obtient des défauts localisés au niveau des bandes de retard du front de solidification, la zone recristallisée entre ces bandes, y compris la zone située sous les bandes d'avance du front de solidification, étant exempte de défauts cristallins.

Ces objets, caractéristiques et avantages ainsi que d'autres de la présente invention seront exposés plus en détail dans la description suivante de modes de réalisation particuliers faite en relation avec les figures jointes parmi lesquelles :

les figures 1A à 1D représentent des vues en coupe d'exemples de structures de discontinuité de silicium sur isolant entraînant l'apparition d'un retard du front de solidification lors d'un balayage par une bande chaude perpendiculaire à la direction des discontinuités ;

les figures 2A à 2D représentent des vues en coupe d'exemples de structures de discontinuité de silicium sur isolant entraînant l'apparition d'une avance du front de solidification lors d'un balayage par une bande chaude perpendiculaire à la direction des discontinuités ;

la figure 3A représente une vue en coupe d'un assemblage de structures de retard et d'avance du front de solidification selon la présente invention ;

la figure 3B représente une vue de dessus très schématique correspondant à la figure 3A ; et

les figures 4A et 4B représentent très schématiquement des vues de dessus de l'allure du front de solidification pour une structure classique et une structure selon la présente invention, respectivement.

Alors que, dans l'art antérieur, pour localiser des défauts lors de la recristallisation d'une couche mince sur isolant par balayage d'une bande fondue, on utilisait indistinctement des structures produisant une avance du front de solidification ou des structures produisant un retard du front de solidification, la présente invention se base sur une séparation de ces types de structures.

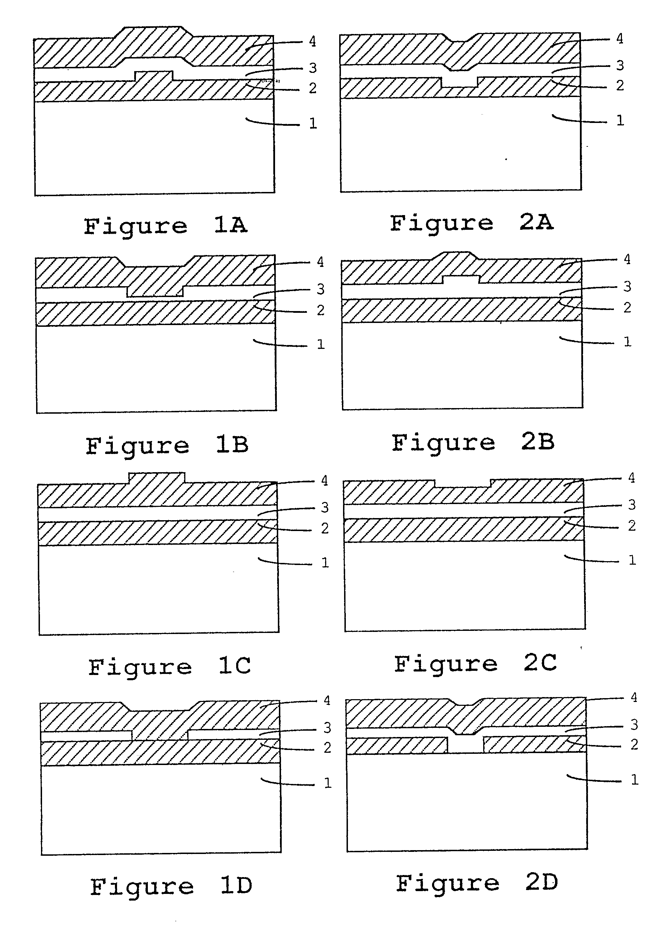

Ainsi, les figures 1A à 1D représentent des structures de discontinuités produisant un retard du front de solidification. Dans ces figures, la zone inférieure est un substrat 1, couramment du silicium monocristallin, la couche hachurée disposée au dessus du substrat est une couche d'un matériau isolant 2, couramment de l'oxyde de silicium ($SiO_2$), la couche non hachurée au dessus de la couche 2 est une couche du matériau à recristalliser 3, couramment du silicium, et la couche hachurée supérieure est une couche d'un produit encapsulant 4, couramment de l'oxyde de silicium.

A la figure 1A, la couche isolante 2 présente une surépaisseur à l'emplacement où l'on souhaite créer la discontinuité. A la figure 1B, la couche de silicium polycristallin présente une zone d'épaisseur réduite à l'emplacement où l'on souhaite créer la discontinuité. A la figure 1C la couche d'encapsulant supérieure présente une surépaisseur à l'emplacement où l'on souhaite créer la discontinuité. A la figure 1D la couche de matériau à recristalliser est interrompue à l'endroit où l'on souhaite créer la discontinuité. Ce dernier mode de réalisation est cité uniquement à titre d'exemple de ce qui est couramment utilisé dans l'art antérieur mais n'est pas préféré selon la présente invention car une recristallisation d'une telle structure entraîne généralement des vides de silicium au voisinage de la discontinuité.

Dans toutes les structures des figure 1A à 1D, après chauffage, la couche de matériau à recristalliser, couramment du silicium, se solidifie plus tard à l'emplacement ou au voisinage de la discontinuité qu'aux autres emplacements. En d'autres termes, la température de solidification est plus basse aux emplacements des discontinuités.

Les figures 2A à 2D représentent des exemples de structures produisant une avance du front de solidification, c'est-à-dire que la température de solidification au voisinage des discontinuités apparaissant dans ces figures est plus élevée que dans les zones non perturbées.

A la figure 2A, la couche isolante 2 présente une plus faible épaisseur à l'emplacement de la discontinuité. A la figure 2B, la couche de matériau à recristalliser présente une surépaisseur à l'emplacement de la discontinuité. A la figure 2C, la couche de produit encapsulant présente une épaisseur plus faible à l'emplacement de discontinuité. A la figure 2D la couche de matériau à recristalliser est en contact avec le substrat. Ce dernier mode de réalisation est mentionné uniquement à titre d'exemple des structures de l'art antérieur mais n'est pas préféré selon la présente invention car de tels contacts entre la couche à recristalliser et le substrat présentent divers inconvénients qui ont déjà été mentionnés dans la littérature.

Une fois réalisée cette classification des bandes de discontinuités en deux catégories, la présente invention propose de combiner sur une même plaquette comportant une couche à recristalliser ces deux types de structures de façon alternée.

A la figure 3A, on a présenté la combinaison d'une structure de retard du front de solidification correspondant à la figure 1A et d'une structure d'avance du front de solidification correspondant à la figure 2C. Ce mode de réalisation constitue un mode de réalisation particulièrement préféré de la présente invention, notamment du fait que, au niveau de la structure d'avance du front de solidification, l'épaisseur de la couche 3 du matériau du matériau à recristalliser n'est pas modifiée et donc, qu'après traitement thermique, le monocristal situé sous cette zone d'avance du front de solidification n'est pas perturbé et peut être utilisé pour la fabrication d'un composant électronique.

La figure 3B représente une vue de dessus schématique d'une structure selon la présente invention comprenant des bandes de discontinuités alternées 10 et 11, respectivement à retard du front de solidification et à avance du front de solidification. On a représenté pour les différencier les structures d'avance du front de solidification plus large que les structures de retard. Ceci correspond à un mode de réalisation préféré mais ne constitue pas une caractéristique nécessaire de la présente invention.

La figure 4A représente très schématiquement l'allure du front de solidification, désigné par la référence 20 dans une structure de discontinuités selon l'art antérieur, où deux bandes parallèles de discontinuités 21 s'étendent perpendiculairement à une zone chaude de fusion de la couche du matériau à recristalliser, c'est-à-dire sensiblement parallèlement au sens de balayage de cette bande fondue. Le front de solidification, dans l'exemple représenté, est retardé au niveau de ces bandes de discontinuités 21. Le premier point de solidification dans la zone utile s'étendant entre les bandes de discontinuités 21 se produit à un emplacement aléatoire à l'intérieur de cette surface libre. Par exemple, comme cela est représenté en figure 4A, le premier point de solidification, dans la direction du balayage de la zone fondue peut être un point 22 voisin de la bande de discontinuité disposée à la droite de la figure. Normalement, ce point correspond à une pointe ou sommet de grain. La pratique montre que le risque de défaut de recristallisation monocristalline est proportionnel à la distance latérale entre la tête de grain et la bande de discontinuité (de localisation de défauts) 21 la plus éloignée. Comme la tête de grain peut se trouver, de la façon représentée, voisine de l'une des bandes de discontinuités, la probabilité de création de défauts (de joints de grain ou de sous-joints de grain), varie comme la distance entre les bandes.

Selon l'invention, comme cela est illustré en figure 4B, le fait de prévoir outre les bandes 21 de retard du front de solidification, une bande médiane 23 d'avance du front de solidification permet de "caler" la pointe de chaque grain sous la bande 23. On double ainsi la distance possible entre les bandes de localisation de défauts 21 tout en gardant la même probabilité d'apparition de joints de grain indésirables dans les zones utiles. En outre, comme cela a été souligné précédemment, la zone comprise sous la bande d'avance du front de solidification peut constituer également une zone utile, notamment quand on choisit le mode de réalisation illustré en figure 2C.

A titre d'exemple pratique, le substrat peut être une plaquette de silicium monocristallin d'un diamètre de l'ordre de 100 mm. La couche isolante 2 peut être obtenue par oxydation thermique et être d'une épaisseur de l'ordre du micromètre. Cete couche peut également être déposée par voie chimique en phase vapeur. Après quoi, on grave éventuellement une partie de l'épaisseur de la couche 2 par photolithogravure puis on dépose une couche de silicium polycristallin ou amorphe par voie chimique en phase vapeur sur une épaisseur de l'ordre de 0,3 à 10 micromètres. La couche d'encapsulant 4 peut être formée par oxydation thermique ou dépôt par voie chimique en phase vapeur et éventuellement gravée par photolithogravure.

Dans le cas particulier du mode de réalisation de la figure 3A, la structure de retard du front de solidification correspondant à celle de la figure 1A pour avoir une largeur de l'ordre de 4 μm et une épaisseur comprise entre la moitié de l'épaisseur de la couche à recristalliser et la valeur de cette épaisseur. En ce qui concerne la structure d'avance de solidification de la figure 3A, correspondant à la structure illustrée en figure 2C, la largeur de l'ouverture pourra être comprise entre 2 et 8 μm et sa profondeur entre la moitié et le quart de l'épaisseur de la couche de produit encapsulant, respectivement.

Pour chacune des autres structures illustrées en figures 1A à 1C et 2A à 2C, on pourra choisir des valeurs appropriées pour les structures de discontinuité. On notera qu'en pratique ces valeurs seront nettement supérieures aux valeurs choisies dans les technologies de graphoépitaxie, notamment en ce qui concerne la profondeur.

Alors que l'on a décrit ci-dessus des modes de réalisation particuliers de la présente invention, celle-ci est susceptible de nombreuses variantes dans la mesure où l'on prévoit des structures appropriées, pour réaliser les discontinuités provoquant respectivement un retard et une avance du front de solidification. D'autre part, alors que l'on a toujours considéré dans les exemples pratiques des bandes de discontinuités orthogonales à la bande de fusion, c'est-à-dire parallèles au sens de déplacement de cette bande de fusion, il sera possible de prévoir des structures obliques ou en croisillons.

**Revendications**

1. Procédé de recristallisation d'un matériau en couche mince déposé sur un subtrat et recouvert d'un produit encapsulant, par chauffage d'une bande dudit matériau au dessus de sa température de fusion et déplacement de cette bande fondue le long du substrat, caractérisé en ce qu'il consiste, avant le traitement par fusion, à modifier, selon des bandes sensiblement orthogonales ou obliques par rapport à la direction de la bande fondue, la structure d'un élément au moins de l'ensemble du substrat (1,2), du matériau (3) et de l'encapsulant (4) pour former des bandes d'une première structure propre à retarder le front de solidification et des bandes d'une autre structure propre à faire avancer le front de solidification, les bandes de la première structure et de la deuxième structure étant alternées.

2. Procédé de recristallisation selon la revendication 1, caractérisé en ce que le substrat comprend une plaquette une silicium monocristallin revêtue d'une couche d'oxyde de silicium, et en ce que le matériau à recristalliser est du silicium et la couche d'encapsulant de l'oxyde de silicium.

3. Procédé de recristallisation selon l'une des revendications 1 ou 2, caractérisé en ce que la structure de retard du front de solidification comprend une surépaisseur de la couche supérieure isolante du substrat (figure 1A).

4. Procédé de recristallisation selon l'une des revendications 1 ou 2, caractérisé en ce que la structure de retard du front de solidification comprend une réduction d'épaisseur de la couche de matériau à recristalliser (figure 1B)

5. Procédé de recristallisation selon l'une des revendications 1 ou 2, caractérisé en ce que la structure de retard du front de solidification comprend une surépaisseur de la couche d'encapsulant (figure 1C).

6. Procédé de recristallisation selon l'une des revendications 1 ou 2, caractérisé en ce que la structure d'avance du front de solidification comprend une réduction d'épaisseur de la couche isolante supérieure du substrat (figure 2A).

7. Procédé de recristallisation selon l'une des revendications 1 ou 2, caractérisé en ce que la structure d'avance du front de solidification comprend une surépaisseur de la couche de matériau à recristalliser (figure 2B).

8. Procédé de recristallisation selon l'une des revendications 1 ou 2, caractérisé en ce que la structure d'avance du front de solidification comprend une réduction d'épaisseur de la couche d'encapsulant (figure 2C).

9. Procédé de recristallisation selon l'une des revendications 1 ou 2, caractérisé en ce que la structure d'avance du front de solidification comprend une réduction d'épaisseur de la couche d'encapsulant et la structure de retard du front de solidification comprend une surépaisseur de la couche supérieure isolante du substrat (figure 3).

Figure 1A

Figure 2A

Figure 1B

Figure 2B

Figure 1C

Figure 2C

Figure 1D

Figure 2D

EP 0 313 481 A1

Figure 3A

Figure 3B

Figure 4A          Figure 4B

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | EP-A-0 199 638  (HAOND)<br>* Figure 5; revendication 1; colonne 6, lignes 11-38; colonne 7, lignes 1-10 *<br>& FR-A-2 580 673 (Cat. D)<br>--- | 1-3,5,6 | C 30 B   13/34<br>H 01 L   21/20 |
| A | US-A-4 565 599  (GEIS et al.)<br>* Figure 2; colonne 3, lignes 1-64 *<br>--- | 1-9 | |
| A,D | JOURNAL OF CRYSTAL GROWTH, vol. 63, no. 3, octobre 1983, pages 527-546, North Holland Publishing Co., Amsterdam, NL; H.I. SMITH et al.:<br>"Silicon-on-insulator by graphoepitaxy and zone-melting recrystallization of patterned films"<br>* Page 541, colonne 1, lignes 5-18 *<br>----- | 1 | |

**DOMAINES TECHNIQUES RECHERCHES (Int. Cl.4)**

C 30 B

Le présent rapport a été établi pour toutes les revendications

| Lieu de la recherche | Date d'achèvement de la recherche | Examinateur |
|---|---|---|
| LA HAYE | 19-01-1989 | COOK S.D. |

EPO FORM 1503 03.82 (P0402)